# EUROPEAN PATENT SPECIFICATION

(11) **EP 3 782 194 B1**
(45) Date of publication and mention of the grant of the patent: **09.07.2025**
(21) Application number: 19712081.9
(22) Date of filing: 04.03.2019
(51) Int. Cl.: H10D 30/67, H10D 86/00

(54) **BODY CONNECTION FOR A SILICON-ON-INSULATOR DEVICE**
KÖRPERKONTAKTIERUNG FÜR EINE SILIZIUM-AUF-ISOLATOR-VORRICHTUNG
CONNEXION DE CORPS DESTINÉE À UN DISPOSITIF SILICIUM SUR ISOLANT

(30) Priority: 20.04.2018 US 201815958792
(43) Date of publication of application: 24.02.2021
(73) Proprietor: QUALCOMM INCORPORATED, San Diego, California 92121-1714 (US)
(72) Inventor: KOLEV, Plamen Vassilev, San Diego, CA 92121 (US); GOKTEPELI, Sinan, San Diego, CA 92121 (US); CLARKE, Peter Graeme, San Diego, CA 92121 (US)
(74) Representative: Klang, Alexander H.
(86) International application number: PCT/US2019/020477
(87) International publication number: WO 2019/203938

(56) References cited:
- US-A- 4 965 213
- US-A1- 2005 133 789
- US-A1- 2012 119 310
- US-A1- 2013 134 585
- US-B1- 6 407 427

## Description

### BACKGROUND

### Claim of Priority

The present Application for Patent claims priority to Application No. 15/958,792 entitled "BODY CONNECTION FOR A SILICON-ON-INSULATOR DEVICE" filed April 20, 2018.

### Field

Aspects of the present disclosure relate to silicon-on-insulator devices, and more particularly, to structures and methods for connecting body of a silicon-on-insulator MOSFET.

### Background

Silicon-on-insulator (SOI) technology refers to the use of a layered silicon-insulator-silicon substrate in place of a conventional silicon substrate in semiconductor manufacturing, especially microelectronics, to reduce parasitic device capacitance, thereby improving performance. An integrated circuit built using SOI devices may show processing speed that is 30% faster than a comparable bulk-based integrated circuit and power consumption being reduced by as much as 80%, which makes it ideal for mobile devices. SOI chips also reduce the soft error rate, which is data corruption caused by cosmic rays and natural radioactive background signals. SOI transistors offer a unique opportunity for CMOS architectures to be more scalable. The buried oxide layer limits the punch-through that may exist on deep sub-micron bulk devices.

Due to the existence of the buried oxide layer, the body of an SOI MOSFET is often floating in circuit design, meaning no connection of the body to a bias voltage. Floating body of an SOI MOSFET results in an effect called floating body effect, a dependency of the body potential on the history of the SOI MOSFET's biasing and the carrier recombination processes. For many applications, leaving body floating causes undesired effects such as kinks in the output characteristics, leading to non-linearity, reduced breakdown voltage, and degraded reliability. For such application, body connection may be needed. However, conventional body connection approaches often comes at a cost of reduced device performance and/or increased device size. Accordingly, it would be beneficial to provide a body connection scheme without substantial performance or area penalty

US 2012/119310 A1 discloses an SOI device with a semiconductor layer with source and channel regions having both a front surface and a back surface plus a back silicidation layer on a portion of the back channel surface;and a back metal connection system including vias and connected to the back silicidation layer.

### SUMMARY

The following presents a simplified summary of one or more implementations to provide a basic understanding of such implementations. This summary is not an extensive overview of all contemplated implementations, and is intended to neither identify key nor critical elements of all implementations nor delineate the scope of any or all implementations. The sole purpose of the summary is to present concepts relate to one or more implementations in a simplified form as a prelude to a more detailed description that is presented later.

In one aspect, a silicon-on-insulator device is defined according to claim 1.

In another aspect, a method is defined according to claim 10.

To accomplish the foregoing and related ends, one or more implementations include the features hereinafter fully described and particularly pointed out in the claims. The following description and the annexed drawings set forth in detail certain illustrative aspects of the one or more implementations. These aspects are indicative, however, of but a few of the various ways in which the principles of various implementations may be employed.

### BRIEF DESCRIPTION OF THE DRAWINGS

FIG. 1a illustrates an example body connection for an SOI MOSFET according to certain aspects of the present disclosure.
FIG. 1b illustrates another example body connection for an SOI MOSFET according to certain aspects of the present disclosure.
FIG. 2 illustrates an example circuitry according to certain aspects of the present disclosure.
FIG. 3 illustrates an exemplary SOI MOSFET with body connection according to certain aspects of the present disclosure.
FIGS. 4a-4e illustrate an exemplary process flow in making a body connection for an SOI MOSFET according to certain aspects of the present disclosure.
FIG. 5 illustrates an exemplary method in making a body connection for an SOI MOSFET according to certain aspects of the present disclosure.

### DETAILED DESCRIPTION

The detailed description set forth below, in connection with the appended drawings, is intended as a description of various aspects and is not intended to represent the only aspects in which the concepts described herein may be practiced. The detailed description includes specific details for the purpose of providing an understanding of the various concepts. However, it will be apparent to those skilled in the art that these concepts may be practiced without these specific details. In some instances, well-known structures and components are shown in block diagram form in order to avoid obscuring such concepts.

Semiconductor-on-insulator (SOI) devices are widely used for their excellent electrical properties including lower threshold voltage, smaller parasitic capacitance, less current leakage and good switching property, etc. Conventionally, the silicon film in the channel region (body) is electrically floating. Leaving the body floating complicates device behavior due to floating body effect, such as parasitic bipolar effect, kink effect, history-dependent characteristics, etc. The floating body effect causes use of SOI devices in certain applications, such as RF, mixed signal, or high speed circuit design, challenging. The traditional remedy to the floating body effect is to provide body connection. However, the efficiency of the conventional body connection is limited and such connection often degrades device performance and consumes significant device area.

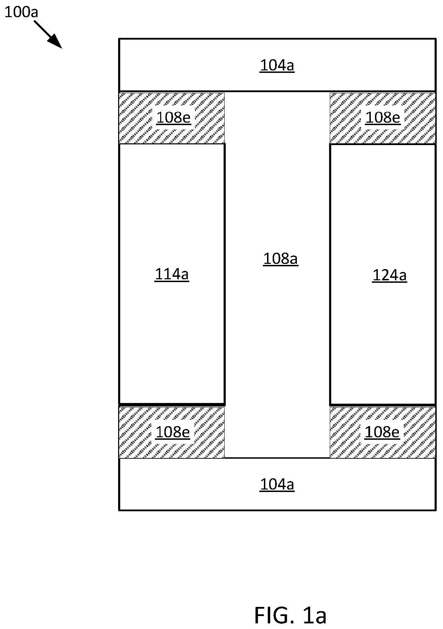

FIG. 1a illustrates an example body connection for an SOI MOSFET according to certain aspects of the present disclosure. From top-down view, the SOI MOSFET 100a comprises an H-shape gate having main gate 108a and gate extensions 108e, a source 114a, a drain 124a, and a body connection 104a in one or both sides of main gate 108a. As illustrated in FIG. 1a, to accommodate the body connection 104a, the main gate 108a is extended through the gate extensions 108e. Such extensions increase device size and add extra parasitic gate capacitance.

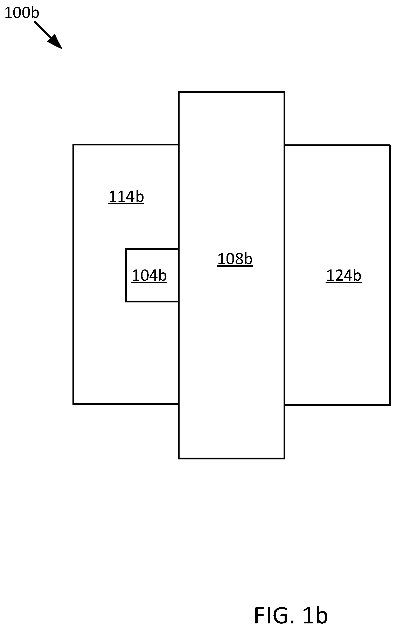

FIG. 1b illustrates another example body connection for an SOI MOSFET according to certain aspects of the present disclosure. From top-down view, the SOI MOSFET 100b comprises a gate 108b, a source 114b, a drain 124b, and a body connection 104b inside the source 114b. Such placement of body connection increases the size of the source thus increase the device size. It also reduces source to channel edge and increases source resistance. As a result, the device performance is degraded. Therefore, it would be beneficial to provide a body connections scheme that minimizes area and performance impact.

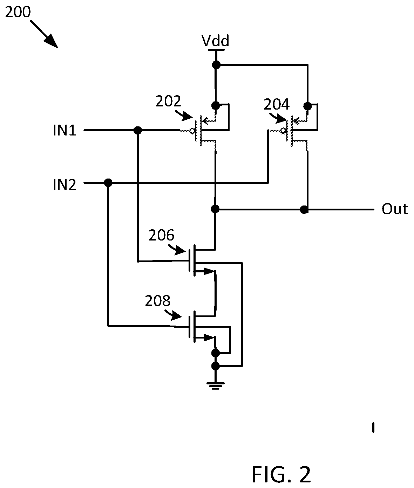

In many circuit designs, the body of an NMOS transistor is connected to a ground while the body of a PMOS transistor is connected to a supply voltage. For an NMOS transistor whose source is connected to the ground or a PMOS transistor whose source is connected to the supply voltage, the body and the source of the transistor are electrically coupled. FIG. 2 illustrates such an example. The circuit 200 is a two-input NAND gate with two inputs IN1 and IN2 and an output OUT. Both sources and both bodies of the PMOS transistors 202 and 204 are electrically coupled and connected to a supply voltage Vdd. While the source of NMOS transistor 206 is not electrically coupled to the body of the NMOS transistor 206, the source and the body of the NMOS transistor 208 are electrically coupled and connected to a ground. In an SOI circuit where the body connection is needed, for a transistor whose body and source are electrically coupled, certain body connection arrangement may be made to minimize the effect on device size or performance.

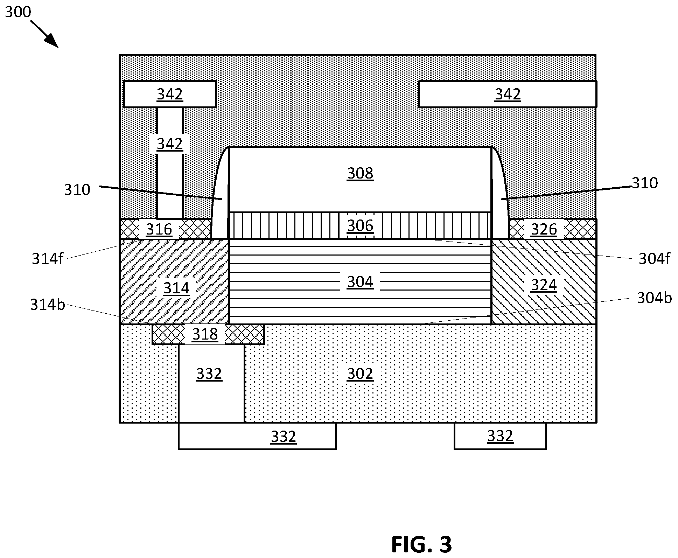

FIG. 3 illustrates an exemplary SOI MOSFET with body connection according to certain aspects of the present disclosure. The MOSFET 300 comprises a back insulating layer 302 and a semiconductor layer on the back insulating layer 302. The semiconductor layer includes a source region 314, a channel region 304, and a drain region 324. The conductive type of the source region 314 and the drain region 324 are opposite to the conductive type of the channel region 304. The source region 314 and the drain region 324 may be of a first conductive type and the channel region 304 may be of a second conductive type. For example, for an N-MOSFET, the source region 314 and the drain region 324 are N-type while the channel region 304 is P-type. For a P-MOSFET, the source region 314 and the drain region 324 are P-type while the channel region 304 is N-type. The source region 314 has a front source surface 314f and a back source surface 314b. The back source surface 314b is opposite to the front source surface 314f. The back source surface 314b is closer to the back insulating layer 302 than the front source surface 314f. Similarly, the channel region 304 has a front channel surface 304f and a back channel surface 304b. The back channel surface 304b is opposite to the front channel surface 304f. The back source channel 314b is closer to the back insulating layer 302 than the front channel surface 304f. A gate insulating layer 306 is on the front channel surface 304f of the channel region 304. A gate conducting layer 308 is on the gate insulating layer 306.

The MOSFET 300 further comprises a back silicidation layer 318 on at least a portion of the back source surface 314b of the source region 314 and a portion of back channel surface 304b of the channel region 304. The back silicidation layer 318 electrically couples the channel region 304 to the source region 314. Thus, through source region 314, the channel region 304 may be connected to a supply voltage for a PMOS transistor or a ground for an NMOS transistor. A separate body connection or body contact is not needed.

The back silicidation layer 318 is formed through a silicidation process, an anneal process resulting in the formation of metal-silicon alloy (silicide) to act as a contact or contact interface for low contact resistance. For example, Titanium may be deposited on silicon to form TiSi₂ as a result of silicidation. Other suitable materials are possible, such as CoSi₂, NiSi, etc.

The MOSFET 300 may further comprise a front silicidation layer 316 on the front source surface 314f and a front silicidation layer 326 on the drain region 324. The front silicidation layer 316 provides an interface for connection of the source region 314, and thus the channel region 304, to a front metal connection system 342. The front metal connection system 342 may include contacts, vias, and multi-level metal layers. The front metal connection system 342 may connect the source region 314 to a supply voltage for a PMOS transistor or a ground for an NMOS transistor. The front metal connection system 342 may connect the source region 314 to other signals.

The MOSFET 300 according to the present invention also comprises a back metal connection system 332. The back metal connection system 332 includes contacts to the back silicidation layer 318 and also includes vias and one or more other metal layers. The source region 314 and/or the channel region 304 may be connected to a supply voltage or a ground or a signal through the back metal connection system 332.

The MOSFET 300 may further comprise a spacer 310. The spacer 310 electrically isolates the source region 314 and the front silicidation layer 316 from the gate conducting layer 308.

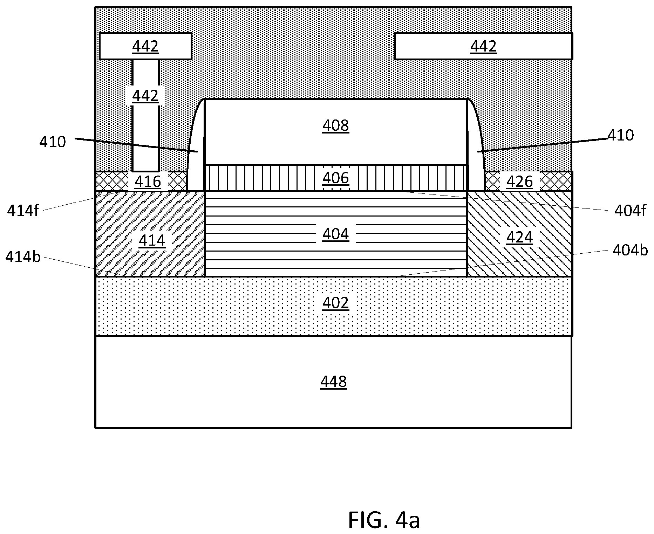

FIGS. 4a-4e illustrate an exemplary process flow in making a body connection for an SOI MOSFET according to certain aspects of the present disclosure. In FIG. 4a, an SOI wafer with MOSFETs is provided. The SOI wafer comprises a sacrificial substrate 448, a back insulating layer 402, at least a MOSFET, and a front metal connection system 442. The MOSFET comprises a source region 414, a channel region 404, and a drain region 424, all on the back insulating layer 402. In addition, the MOSFET may comprise a front silicidation layer 416 on the source region 414 and a front silicidation layer 426 on the drain region 424. The source region 414 has a front source surface 414f and a back source surface 414b. The channel region 404 has a front channel surface 404f and a back channel surface 404b. The MOSFET also comprises a gate insulating layer 406 on the channel region 404, a gate conducting layer 408 on the gate insulating layer 406, and a spacer 410 at the sides of the gate conducting layer 408. Further, the front metal connection system 442 provides supply voltage, ground, and/or signal connection for the MOSFET.

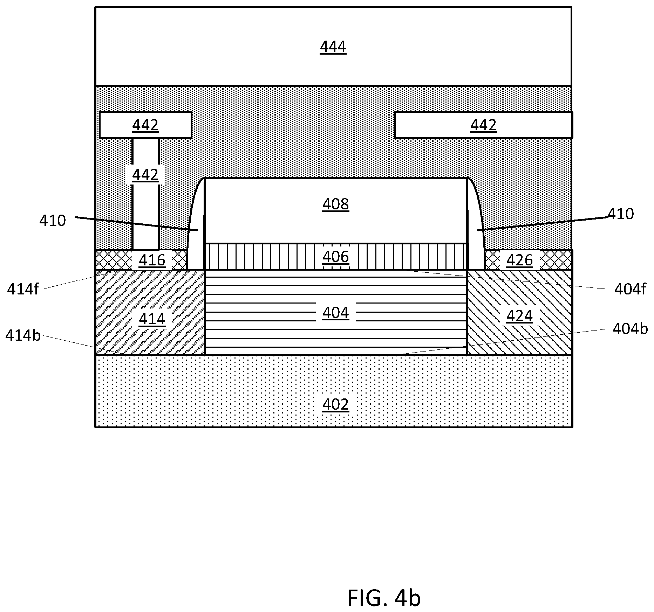

In FIG. 4b, the SOI wafer is bonded to a handle wafer 444. After the bonding of the handle wafer 444, the sacrificial substrate 448 is removed, exposing the back insulating layer 402.

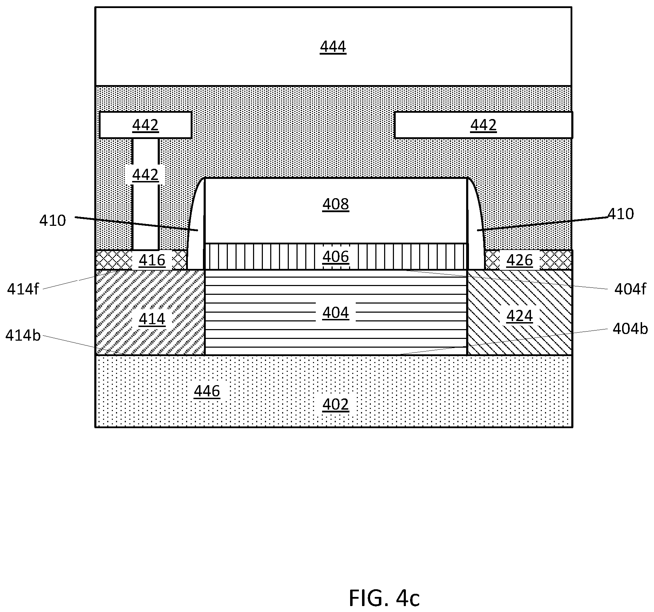

In FIG. 4c, the back insulating layer 402 is patterned and etched with an opening 446. The opening 446 exposes a portion or all of the back source surface 414b and a portion or all of the back channel surface 404b.

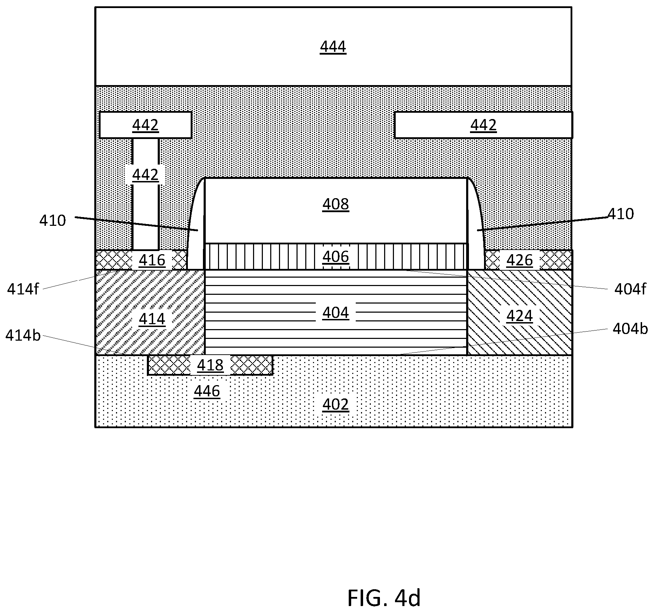

In FIG. 4d, a back silicidation layer 418 is formed over the exposed portion of the back source surface 414b and the exposed portion of the back channel surface 404b. The back silicidation layer 418 electrically couples the channel region 404 to the source region 414. Thus, through source region 414, the channel region 404 may be connected to a supply voltage for a PMOS transistor or a ground for an NMOS transistor.

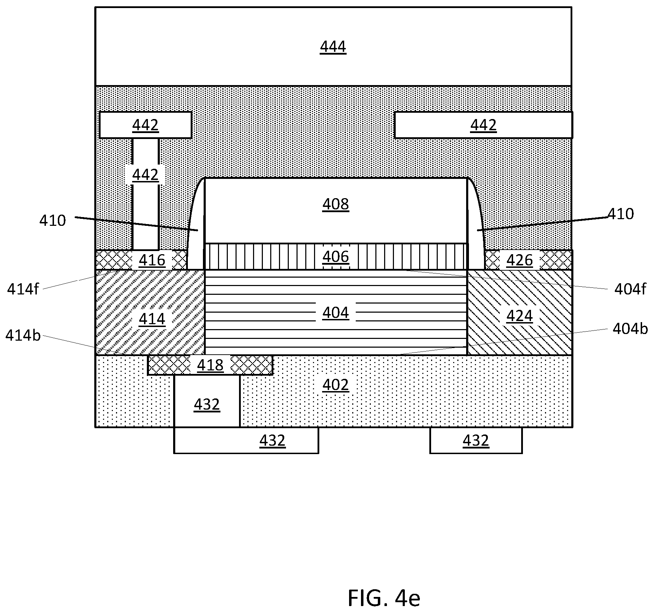

In FIG. 4e, a back metal connection system 432 is formed. The back metal connection system 432 includes contacts to the back silicidation layer 418, vias, and one or more other metal layers. The source region 414 and/or the channel region 404 may be connected to a supply voltage, a ground, or a signal through the back metal connection system 432.

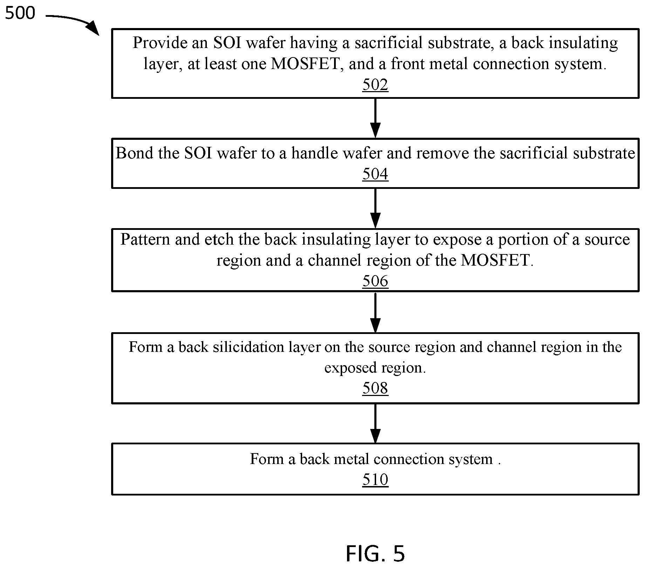

FIG. 5 illustrates an exemplary method 500 in making a body connection for an SOI MOSFET according to certain aspects of the present disclosure. At 502, an SOI wafer with MOSFETs is provided. The SOI wafer comprises a sacrificial substrate (e.g., the sacrificial substrate 448), a back insulating layer (e.g., the back insulating layer 302 or 402), at least a MOSFET, and a front metal connection system (e.g., the front metal connection system 342 or 442). The MOSFET comprises a source region (e.g., the source region 314 or 414), a channel region (e.g., the channel region 304 or 404), and a drain region (e.g., the drain region 324 or 424), all on the back insulating layer. In addition, the MOSFET may comprise a front silicidation layer (e.g., the front silicidation layer 316 or 416) on the source region and a front silicidation layer (e.g., the front silicidation layer 326 or 426) on the drain region. The MOSFET also comprises a gate insulating layer (e.g., the gate insulating layer 306 or 406) on the channel region, a gate conducting layer (e.g., the gate conducting layer 308 or 408) on the gate insulating layer, and a spacer (e.g., the spacer 310 or 410) at the sides of the gate conducting layer. Further, The front metal connection system provides supply voltage, ground, and/or signal connection for the MOSFET.

At 504, the SOI wafer is bonded to a handle wafer (e.g., the handle wafer 444). After the bonding of the handle wafer, the sacrificial substrate is removed, exposing the back insulating layer.

At 506, the back insulating layer is patterned and etched with an opening (e.g., the opening 446). The opening exposes a portion or all of the back source surface and a portion or all of the back channel surface.

At 508, a back silicidation layer (e.g., the back silicidation layer 318 or 418) is formed in the exposed back source surface and the exposed back channel surface. The back silicidation layer electrically couples the channel region to the source region. Thus, through source region, the channel region may be connected to a supply voltage for a PMOS transistor or a ground for an NMOS transistor.

At 510, a back metal connection system (e.g., the back metal connection system 332 or 432) may be formed. The back metal connection system may include contacts to the back silicidation layer, vias, and one or more metal layers. The source region and/or the channel region may be connected to a supply voltage or a ground or a signal through the back metal connection system.

The previous description of the disclosure is provided to enable any person skilled in the art to make or use the disclosure. Various modifications to the disclosure will be readily apparent to those skilled in the art.

Thus, the disclosure is not intended to be limited to the examples described herein. The invention is defined by the claims.

## Claims

1. A silicon-on-insulator device, comprising:
a back insulating layer (302);
a semiconductor layer on the back insulating layer (302), wherein the semiconductor layer includes a source region (314) of a first conductive type having a front source surface and a back source surface, a channel region (304) of a second conductive type having a front channel surface and a back channel surface, and a drain region (324) of the first conductive type;
a gate insulating layer (306) on the front channel surface of the channel region;
a gate conducting layer (308) on the gate insulating layer (306); and
a back silicidation layer (318) on at least a portion of the back source surface and at least a portion of the back channel surface;
a back metal connection system (332) connected to the back silicidation layer (318), wherein the back metal connection system includes vias and one or more metal layers, wherein the one or more metal layers are located on a surface of the back insulating layer opposite to the semiconductor layer, and wherein the vias are located between the back silicidation layer (318) and the one or more metal layers.

2. The silicon-on-insulator device of claim 1, wherein the back silicidation layer (318) is configured to electrically connect the channel region to the source region (314).

3. The silicon-on-insulator device of claim 2, wherein the channel region (304) is electrically connected to a supply voltage or a ground through the source region (314).

4. The silicon-on-insulator device of claim 1, wherein the first conductive type is opposite to the second conductive type.

5. The silicon-on-insulator device of claim 4, wherein the first conductive type is N-type.

6. The silicon-on-insulator device of claim 4, wherein the first conductive type is P-type.

7. The silicon-on-insulator device of claim 1, further comprising a front silicidation layer (316) on the front source surface.

8. The silicon-on-insulator device of claim 7, wherein the front silicidation layer (316) is isolated from the gate conducting layer by a spacer.

9. The silicon-on-insulator device of claim 1, wherein the back metal connection system (332) provides connection of a supply voltage or a ground or a signal to the source region and the channel region.

10. A method (500), comprising:
providing (502) a silicon-on-insulator wafer having a front metal connection system, a MOSFET, a back insulating layer, and a sacrificial substrate, wherein the MOSFET has a source region having a front source surface and a back source surface, a drain region, and a channel region having a front channel surface and a back channel surface;
bonding (504) the silicon-on-insulator wafer to a handle wafer;
removing the sacrificial substrate;
patterning and etching (506) the back insulating layer to expose at least a portion of the back source surface and the back channel surface of the MOSFET; and
forming (508) a back silicidation layer on the exposed back source region and the exposed back channel region;
forming (510) a back metal connection system connected to the back silicidation layer, wherein forming the back metal connection system includes forming vias and one or more metal layers, wherein the one or more metal layers are located on a surface of the back insulating layer opposite to the semiconductor layer, and wherein the vias are located between the back silicidation layer and the one or more metal layers.

11. The method (500) of claim 10, wherein the back silicidation layer is configured to electrically connect the channel region to the source region, wherein the channel region is electrically coupled to a supply voltage or a ground through the source region.

12. The method (500) of claim 10, wherein the source region and the drain region is of a first conductive type and the channel region is of a second conductive type opposite to the first conductive type.

13. The method (500) of claim 12, wherein the first conductive type is N-type, or wherein the first conductive type is P-type.

14. The method (500) of claim 10, further comprising forming a front silicidation layer on the front source surface, wherein the front silicidation layer is isolated from a gate conducting layer by a spacer.

15. The method (500) of claim 10, wherein the back metal connection system provides connection of a supply voltage or a ground or a signal to the source region and the channel region.

## Patentansprüche

1. Ein Silicon-on-Insulator (SOI)-Bauelement, aufweisend:
eine hintere isolierende Schicht (302),
eine Halbleiterschicht auf der hinteren isolierenden Schicht (302), wobei die Halbleiterschicht einen Source-Bereich (314) eines ersten Leitfähigkeitstyps mit einer vorderen Source-Fläche und einer hinteren Source-Fläche, einen Kanalbereich (304) eines zweiten Leitfähigkeitstyps mit einer vorderen Kanalfläche und einer hinteren Kanalfläche und einen Drain-Bereich (324) des ersten Leitfähigkeitstyps aufweist,
eine Gate-Isolationsschicht (306) auf der vorderen Kanalfläche des Kanalbereichs,
eine Gate-Leitungsschicht (308) auf der Gate-Isolationsschicht (306), und
eine hintere Silizidierungsschicht (318) auf wenigstens einem Teil der hinteren Source-Fläche und wenigstens einem Teil der hinteren Kanalfläche,
ein hinteres Metallverbindungssystem (332), das mit der hinteren Silizidierungsschicht (318) verbunden ist, wobei das hintere Metallverbindungssystem Durchkontaktierungen und eine oder mehrere Metallschichten umfasst, wobei die eine oder die mehreren Metallschichten auf einer Fläche der hinteren Isolationsschicht gegenüber der Halbleiterschicht angeordnet sind, und wobei die Durchkontaktierungen zwischen der hinteren Silizidierungsschicht (318) und der einen oder den mehreren Metallschichten angeordnet sind.

2. SOl-Bauelement nach Anspruch 1, wobei die hintere Silizidierungsschicht (318) konfiguriert ist, um den Kanalbereich elektrisch mit dem Source-Bereich (314) zu verbinden.

3. SOI-Bauelement nach Anspruch 2, wobei der Kanalbereich (304) über den Source-Bereich (314) elektrisch mit einer Versorgungsspannung oder einer Erde verbunden ist.

4. SOI-Bauelement nach Anspruch 1, wobei der erste Leitfähigkeitstyp dem zweiten Leitfähigkeitstyp entgegengesetzt ist.

5. SOI-Bauelement nach Anspruch 4, wobei der erste Leitfähigkeitstyp ein N-Typ ist.

6. SOI-Bauelement nach Anspruch 4, wobei der erste Leitfähigkeitstyp ein P-Typ ist.

7. SOl-Bauelement nach Anspruch 1, das weiterhin eine vordere Silizidierungsschicht (316) auf der vorderen Source-Fläche aufweist.

8. SOl-Bauelement nach Anspruch 7, wobei die vordere Silizidierungsschicht (316) durch ein Abstandsglied von der Gate-Leitungsschicht isoliert ist.

9. SOl-Bauelement nach Anspruch 1, wobei das hintere Metallverbindungssystem (332) eine Verbindung einer Versorgungsspannung einer Erde oder eines Signals mit dem Source-Bereich und dem Kanalbereich vorsieht.

10. Ein Verfahren (500), aufweisend:
Vorsehen (502) eines Silicon-on-Insulator (SOI)-Wafers, der ein vorderes Metallverbindungssystem, einen MOSFET, eine hintere Isolationsschicht und ein Opfersubstrat aufweist, wobei der MOSFET einen Source-Bereich mit einer vorderen Source-Fläche und einer hinteren Source-Fläche, einen Drain-Bereich und einen Kanalbereich mit einer vorderen Kanalfläche und einer hinteren Kanalfläche aufweist,
Bonden (504) des SOI-Wafers mit einem Handhabungswafer,
Entfernen des Opfersubstrats,
Mustern und Ätzen (506) der hinteren Isolationsschicht, um wenigstens einen Teil der hinteren Source-Fläche und der hinteren Kanalfläche des MOSFET freizulegen, und
Ausbilden (508) einer hinteren Silizidierungsschicht auf dem freigelegten hinteren Source-Bereich und dem freigelegten hinteren Kanalbereich,
Ausbilden (510) eines hinteren Metallverbindungsystems, das mit der hinteren Silizidierungsschicht verbunden ist, wobei das Ausbilden des hinteren Metallverbindungssystems das Ausbilden von Durchkontaktierungen und einer oder mehrerer Metallschichten umfasst, wobei die eine oder die mehreren Metallschichten auf einer Fläche der hinteren Isolationsschicht gegenüber der Halbleiterschicht angeordnet sind und wobei die Durchkontaktierungen zwischen der hinteren Silizidierungsschicht und der einen oder den mehreren Metallschichten angeordnet sind.

11. Verfahren (500) nach Anspruch 10, wobei die hintere Silizidierungsschicht konfiguriert ist, um den Kanalbereich elektrisch mit dem Source-Bereich zu verbinden, wobei der Kanalbereich über den Source-Bereich elektrisch mit einer Versorgungsspannung oder einer Erde gekoppelt ist.

12. Verfahren (500) nach Anspruch 10, wobei der Source-Bereich und der Drain-Bereich von einem ersten Leitfähigkeitstyp sind und der Kanalbereich von einem zweiten Leitfähigkeitstyp, der dem ersten Leitfähigkeitstyp entgegengesetzt ist, ist.

13. Verfahren (500) nach Anspruch 12, wobei der erste Leitfähigkeitstyp ein N-Typ ist oder wobei der erste Leitfähigkeitstyp ein P-Typ ist.

14. Verfahren (500) nach Anspruch 10, das weiterhin das Ausbilden einer vorderen Silizidierungsschicht auf der vorderen Source-Fläche aufweist, wobei die vordere Silizidierungsschicht durch ein Abstandsglied von einer Gate-Leitungsschicht isoliert ist.

15. Verfahren (500) nach Anspruch 10, wobei das hintere Metallverbindungssystem eine Verbindung einer Versorgungsspannung, einer Erde oder eines Signals mit dem Source-Bereich und dem Kanalbereich vorsieht.

## Revendications

1. Dispositif silicium sur isolant, comprenant :
une couche isolante arrière (302) ;
une couche semiconductrice sur la couche isolante arrière (302), dans lequel la couche semiconductrice comporte une région de source (314) d'un premier type de conductivité ayant une surface de source avant et une surface de source arrière, une région de canal (304) d'un deuxième type de conductivité ayant une surface de canal avant et une surface de canal arrière, et une région de drain (324) du premier type de conductivité ;
une couche isolante de grille (306) sur la surface de canal avant de la région de canal ;
une couche conductrice de grille (308) sur la couche isolante de grille (306) ; et
une couche de siliciuration arrière (318) sur au moins une partie de la surface de source arrière et au moins une partie de la surface du canal arrière ;
un système de connexion métallique arrière (332) connecté à la couche de siliciuration arrière (318), dans lequel le système de connexion métallique arrière comporte des vias et une ou plusieurs couches métalliques, dans lequel les une ou plusieurs couches métalliques sont situées sur une surface de la couche isolante arrière opposée à la couche semiconductrice, et dans lequel les vias sont situés entre la couche de siliciuration arrière (318) et les une ou plusieurs couches métalliques.

2. Dispositif silicium sur isolant selon la revendication 1, dans lequel la couche de siliciuration arrière (318) est configurée pour connecter électriquement la région de canal à la région de source (314).

3. Dispositif silicium sur isolant selon la revendication 2, dans lequel la région de canal (304) est connectée électriquement à une tension d'alimentation ou à une masse par l'intermédiaire de la région de source (314).

4. Dispositif silicium sur isolant selon la revendication 1, dans lequel le premier type de conductivité est opposé au deuxième type de conductivité.

5. Dispositif silicium sur isolant selon la revendication 4, dans lequel le premier type de conductivité est le type N.

6. Dispositif silicium sur isolant selon la revendication 4, dans lequel le premier type de conductivité est le type P.

7. Dispositif silicium sur isolant selon la revendication 1, comprenant en outre une couche de siliciuration avant (316) sur la surface de source avant.

8. Dispositif silicium sur isolant selon la revendication 7, dans lequel la couche de siliciuration avant (316) est isolée de la couche conductrice de grille par un espaceur.

9. Dispositif silicium sur isolant selon la revendication 1, dans lequel le système de connexion métallique arrière (332) fournit une connexion d'une tension d'alimentation ou d'une masse ou d'un signal à la région de source et à la région de canal.

10. Procédé (500) comprenant :
la fourniture (502) d'une plaquette de silicium sur isolant ayant un système de connexion métallique avant, un MOSFET, une couche isolante arrière et un substrat sacrificiel, dans lequel le MOSFET a une région de source ayant une surface de source avant et une surface de source arrière, une région de drain et une région de canal ayant une surface de canal avant et une surface de canal arrière ;
le collage (504) de la plaquette de silicium sur isolant sur une plaquette de manipulation ;
le retrait du substrat sacrificiel ;
le dessin et la gravure (506) de la couche isolante arrière pour exposer au moins une partie de la surface de source arrière et de la surface du canal arrière du MOSFET ; et
la formation (508) d'une couche de siliciuration arrière sur la région de source arrière exposée et la région de canal arrière exposée ;
la formation (510) d'un système de connexion métallique arrière connecté à la couche de siliciuration arrière, dans lequel la formation du système de connexion métallique arrière comporte la formation de vias et d'une ou de plusieurs couches métalliques, dans lequel les une ou plusieurs couches métalliques sont situées sur une surface de la couche isolante arrière opposée à la couche semiconductrice, et dans lequel les vias sont situés entre la couche de siliciuration arrière et les une ou plusieurs couches métalliques.

11. Procédé (500) selon la revendication 10, dans lequel la couche de siliciuration arrière est configurée pour connecter électriquement la région de canal à la région de source, dans lequel la région de canal est connectée électriquement à une tension d'alimentation ou à une masse par l'intermédiaire de la région de source.

12. Procédé (500) selon la revendication 10, dans lequel la région de source et la région de drain sont d'un premier type de conductivité et la région de canal est d'un deuxième type de conductivité opposé au premier type de conductivité.

13. Procédé (500) selon la revendication 12, dans lequel le premier type de conductivité est le type N, ou dans lequel le premier type de conductivité est le type P.

14. Procédé (500) selon la revendication 10, comprenant en outre la formation d'une couche de siliciuration avant sur la surface de source avant, dans lequel la couche de siliciuration avant est isolée de la couche conductrice de grille par un espaceur.

15. Procédé (500) selon la revendication 10, dans lequel le système de connexion métallique arrière fournit une connexion d'une tension d'alimentation ou d'une masse ou d'un signal à la région de source et à la région de canal.
